# EUROPÄISCHE PATENTSCHRIFT

(11) **EP 4 427 284 B1**
(45) Veröffentlichungstag und Bekanntmachung des Hinweises auf die Patenterteilung: **14.01.2026**
(21) Anmeldenummer: 22786880.9
(22) Anmeldetag: 30.09.2022
(51) Int. Cl.: H01M 8/0228, H01M 8/0217, H01M 8/1018, H01M 8/18, C25B 1/04, C25B 9/75, C25B 11/053, C25B 11/077, C25B 11/061, H01M 8/0206

(54) **SCHICHTSYSTEM, ELEKTRODENPLATTE MIT EINEM SOLCHEN SCHICHTSYSTEM, VERFAHREN ZU DEREN HERSTELLUNG, SOWIE BRENNSTOFFZELLE, ELEKTROLYSEUR ODER REDOX-FLOW-ZELLE**
LAYERED SYSTEM, ELECTRODE PLATE WITH SUCH A SYSTEM, METHOD OF MANUFACTURING IT, AS WELL AS FUEL CELL, ELECTROLYSER OR REDOX-FLOW BATTERY
SYSTÈME DE COUCHES, ÉLECTRODE LE COMPRENANT, SA MÉTHODE DE FABRICATION, AINSI QUE PILE À COMBUSTIBLE, ÉLECTROLYSEUR ET PILE À FLUX RÉDOX

(30) Priorität: 02.11.2021 DE 102021128462
(43) Veröffentlichungstag der Anmeldung: 11.09.2024
(73) Patentinhaber: Schaeffler Technologies AG & Co. KG, 91074 Herzogenaurach (DE)
(72) Erfinder: VIVEKANANTHAN, Jeevanthi, 91074 Herzogenaurach (DE); DOBRENIZKI, Ladislaus, 91315 Höchstadt (DE); BAECHSTAEDT, Romina, Wooster, OH 44691 (US); KRUPPE, Nathan, 90408 Nürnberg (DE); STUMPF, Jan Martin, 91054 Erlangen (DE); HECKL, Astrid, 91183 Abenberg (DE)
(74) Vertreter: Schaeffler Technologies
(86) Internationale Anmeldenummer: PCT/DE2022/100729
(87) Internationale Veröffentlichungsnummer: WO 2023/078496

(56) Entgegenhaltungen:
- EP-A1- 2 040 304
- WO-A1-2011/000211
- WO-A1-2011/108612
- WO-A1-2019/135114
- CN-A- 106 920 977
- JP-A- 2021 050 411
- KR-A- 20160 140 260
- LIU H ET AL: "Transparent conducting oxides for electrode applications in light emitting and absorbing devices", SUPERLATTICES AND MICROSTRUCTURES, ELSEVIER, GB, vol. 48, no. 5, 6 September 2010 (2010-09-06), pages 458 - 484, XP027417770, ISSN: 0749-6036, [retrieved on 20100906]

## Beschreibung

Die Erfindung betrifft ein Schichtsystem zum Beschichten eines Substrats zur Ausbildung einer Elektrodenplatte, umfassend zumindest eine Beschichtung (1a) aus Metalloxid. Die Erfindung betrifft weiterhin eine Elektrodenplatte umfassend ein Substrat und ein solches Schichtsystem und ein Verfahren zu deren Herstellung. Weiterhin betrifft die Erfindung eine Brennstoffzelle, einen Elektrolyseur oder eine Redox-Flow-Zelle umfassend mindestens eine solche Elektrodenplatte.

Aus der DE 100 58 337 A1 ist bereits eine Bipolarplatte für eine Brennstoffzelle oder einen Elektrolyseur bekannt, bei welcher auf mindestens einer Seite eines Blechs eine leitfähige und korrosionsbeständige Schutzbeschichtung aus einem Metalloxid gebildet ist. Das Metalloxid ist insbesondere aus einem Oxid der Elemente oder Legierungen aus der Gruppe umfassend Zinn, Zink, Indium gebildet. Eine die Leitfähigkeit sicherstellende Dotierung aus mindestens einem Element der Gruppe umfassend Aluminium, Chrom, Silber, Bor, Fluor, Antimon, Chlor, Brom, Phosphor, Molybdän, Kohlenstoff kann dabei im Metalloxid vorhanden sein. Als Bleche werden solche aus Aluminium, Kupfer, rostfreiem Stahl, verchromtem rostfreiem Stahl, Titan, Titan-Legierungen, und eisenhaltigen Verbindungen verwendet, die eine Beschichtung aufweisen können aus mindestens einem der Elemente Zinn, Zink, Nickel, Chrom.

Es ist Aufgabe der Erfindung, ein verbessertes Schichtsystem für eine Elektrodenplatte bereitzustellen und eine derartige Elektrodenplatte bereitzustellen. Weiterhin ist es Aufgabe der Erfindung, ein Verfahren zur Herstellung der Elektrodenplatte abzugeben und eine Brennstoffzelle, einen Elektrolyseur oder eine Redox-Flow-Zelle mit mindestens einer solchen Elektrodenplatte vorzuschlagen.

Die Aufgabe wird für das Schichtsystem zum Beschichten eines Substrats zur Ausbildung einer Elektrodenplatte, umfassend zumindest eine erste Beschichtung aus Metalloxid, wobei die mindestens eine erste Beschichtung eine homogene, polykristalline dotierte Indium-Zinn-Oxid-Schicht ist und darauf eine Deckschicht in Form einer polykristallinen dotierten Indium-Zinn-Oxid-Schicht aus einem Netzwerk an Nanofasern ausgebildet ist, wobei das Indium-Zinn-Oxid der mindestens einen ersten Beschichtung und der Deckschicht mit mindestens einem Element der Gruppe umfassend Kohlenstoff, Stickstoff, Bor, Fluor, Wasserstoff, Phosphor, Schwefel, Chlor, Brom, Aluminium, Silizium, Titan, Chrom, Kobalt, Nickel, Kupfer, Zirkon, Niob, Molybdän, Silber, Antimon, Hafnium, Tantal, Wolfram dotiert ist.

Das Schichtsystem zeichnet sich durch eine hohe Langzeitstabilität bei gleichzeitig hoher elektrischer Leitfähigkeit und geringen Kosten aus, da es weitgehend oder ohne Edelmetall auskommt. Zudem gewährleistet das Schichtsystem einen ausgezeichneten Korrosionsschutz für ein insbesondere metallisches Grundmaterial oder Substrat einer Elektrodenplatte, insbesondere einer Bipolarplatte. Ein Indium-Zinn-Oxid wird nachfolgend abgekürzt auch als ITO (indium tin oxide) bezeichnet.

Das Schichtsystem ist dabei vorzugsweise durch ein PVD- oder ein CVD-Verfahren (PVD: Physical Vapour Depostion; CVD: Chemical Vapour Deposition) oder ein PACVD-Verfahren (PACVD: Plasma-assisted Chemical Vapour Deposition) gebildet.

Als Nanofasern werden längliche oder stengelförmige Strukturen angesehen, die einen Durchmesser bis zu 200 nm und eine Länge bis zu 1000nm aufweisen. Die Nanofasern können dabei spitz zulaufend ausgebildet sein.

Zur Ausbildung einer Deckschicht aus einem Netzwerk an Nanofasern wird hier auf die Veröffentlichung "3D ITO-nanowire networks as transparent electrode for all terrain substrate", Qiang Li et al., Scientific Reports (2019) 9:4983, verwiesen. Siehe unter: https://doi.org/10.1038/s41598-019-41579-2

ITO-Nanofasern konnten seitens der Anmelderin für Brennstoffzellen-, Elektrolyse- und Redox-Flow-Bipolarplatten auch durch nicht-reaktive Sputter-Technik mit einer Abscheidrate von 40 Å/min und aus einem Target aus In₂O₃:SnO₂ bei einer Konzentration von 90:10 at.-% hergestellt werden. Die Temperatur sowie der SnO₂-Gehalt sind die Hauptwachstumsfaktoren bei der Herstellung der ITO-Nanofasern. Das Wachstum erfolgt durch Atome, die vom Target verdampft und auf einem Substrat abgeschieden werden. Der Temperaturbereich für das Wachstum liegt bei 150 °C bis 500 °C. Durch Erhöhen der Temperatur werden die mittlere Faserlänge und der mittlere Durchmesser der Fasern erhöht, der Nachbarabstand verringert und die Anzahl an Fasern pro Flächeneinheit erhöht. Der SnO₂-Gehalt liegt dabei bevorzugt bei maximal 30 at.-%. Die Entwicklung der mittleren Länge sowie des mittleren Durchmessers der Nanofasern hängt von der Abscheidungszeit ab. Bevorzugt wachsen die ITO-Nanofasern auf einer dünnen, dichten ITO-Schicht auf.

Eine bevorzugte Schichtdicke des Schichtsystems beträgt kleiner 1 µm und liegt insbesondere im Bereich von 0.01 bis 0,5 µm.

Eine Konzentration der Elemente der Dotierung im Indium-Zinn-Oxid liegt insbesondere im Bereich von < 0 bis 20at.-%.

Besonders bevorzugt sind hierbei erste Beschichtungen und Deckschichten aus Indium-Zinn-Oxid, die einen Indiumanteil im Bereich von 70 bis 90 at.-% aufweisen. Besonders bevorzugt sind Indiumanteile im Bereich von 75 bis 85 at.-%, die eine hohe elektrische Leitfähigkeit aufweisen.

Insbesondere haben sich folgende Schichtsysteme zum Beschichten eines metallischen Substrats, bevorzugt aus Stahl, insbesondere austenitischem Stahl oder austenitischem Edelstahl, zur Ausbildung einer Elektrodenplatte als vorteilhaft erwiesen:

### Beispiel 1:

| | |
|---|---|
| Erste Beschichtung: | ITO Schichtdicke: 100 nm |
| | Dotierung: 10 at.-% Stickstoff |
| Deckschicht: | Indium-Zinn-Oxid-Nanofasern mit 80 Vol.-% Indiumanteil |
| | Schichtdicke: 100 nm |
| | Dotierung: 3 - 5 at.-% Kupfer |

### Beispiel 2:

| | |
|---|---|
| Erste Beschichtung: | ITO Schichtdicke: 100 nm |
| | Dotierung: 5 at.-% Titan |
| Weitere 1. Beschichtung: | ITO Schichtdicke: 200 nm |
| | Dotierung: 5 at.-% Stickstoff |
| Deckschicht: | Indium-Zinn-Oxid-Nanofasern mit 90 Vol.-% Indiumanteil |
| | Schichtdicke: 100 nm |
| | Dotierung: 3 - 5 at.-% Kohlenstoff |

Die Aufgabe wird für eine Elektrodenplatte umfassend ein metallisches Substrat sowie ein erfindungsgemäßes Schichtsystem gelöst mit einem Aufbau der Elektrodenplatte in der Reihenfolge:
Substrat,
mindestens eine erste Beschichtung aus Metalloxid und
Deckschicht aus Nanofasern.

Das Substrat weist bevorzugt eine Dicke im Bereich von 0,001 bis 5mm auf.

Insbesondere ist das Substrat aus einer Eisenlegierung, insbesondere aus Stahl, oder aus Titan oder einer Titan-Legierung oder Aluminium oder einer Aluminiumlegierung oder Zink oder einer Zink-Legierung oder einer Zinn-Legierung oder Kupfer oder einer Kupferlegierung oder Nickel oder einer Nickellegierung oder Silber oder einer Silberlegierung oder Chrom oder einer Chromlegierung oder auf Graphit-Basis gebildet.

Vorzugsweise handelt es sich hier um eine Elektrodenplatte mit einem metallischen Substrat beziehungsweise einer metallischen Trägerplatte. Eine Trägerplatte kann dabei ein- oder mehrteilig ausgebildet sein. Insbesondere ist die Elektrodenplatte als Bipolarplatte ausgebildet.

Erfindungsgemäß umfasst das Verfahren zur Herstellung einer erfindungsgemäßen Elektrodenplatte die folgenden Schritte:
Bereitstellen des Substrats;
Ausbilden der Unterschicht auf einer Oberfläche des metallischen Substrats;
Ausbilden der mindestens einen ersten Beschichtung auf dem Substrat,
Ausbilden der Deckschicht auf der mindestens einen ersten Beschichtung,
wobei die mindestens eine erste Beschichtung und die Deckschicht aus Metalloxid auf dem Substrat mittels nicht-reaktiven Sputterns mit einem amorphen Gefüge ausgebildet werden; und
Tempern der mindestens einen ersten Beschichtung und der Deckschicht bei einer Temperatur im Bereich von 220 bis 400 °C derart, dass das amorphe Gefüge in ein polykristallines Gefüge umgewandelt wird.

Es handelt sich dabei um ein im Serienmaßstab kostengünstig durchführbares Abscheideverfahren, mit welchem sich auch die Nanofasern erzeugen lassen.

Die Aufgabe wird weiterhin für eine Brennstoffzelle, insbesondere Sauerstoff-Wasserstoff-Brennstoffzelle, oder einen Elektrolyseur, insbesondere zur Erzeugung von Wasserstoff und Sauerstoff aus Wasser, oder eine Redox-Flow-Zelle, insbesondere umfassend mindestens einen organischen Elektrolyten, gelöst, umfassend mindestens eine erfindungsgemäße Elektrodenplatte. Die Brennstoffzelle umfasst dabei vorzugsweise mindestens eine Polymerelektrolytmembrane.

Im Test zeigte das Schichtsystem eine Stabilität bis mind. 1,4 V gegenüber Ag/AgCl ex-situ unter harschen Brennstoffzellenbedingungen in einem 0.5 mM H₂SO₄-Elektrolyten bei pH3 + 0.1ppm HF, und ist damit vergleichbar mit der Edelmetallbeschichtung. Der Kontaktwiderstand vor und nach dieser elektrochemischen Belastung (Parameter siehe oben) beträgt < 3 mOhm_{*}cm² bei einem Anpressdruck von 100N/cm² und einer Messtemperatur von 24 °C.

Die Korrosionsströme betragen < 10⁻⁷ A/cm² unter den relevanten Brennstoffzellen-Anwendungspotentialen bis 1,0 V gegenüber Ag/AgCl.

Optisch und mikroskopisch wurde kein Schicht- und Substratangriff bis mindestens 1,4 V gegenüber Ag/AgCl festgestellt. Als Substrat wurde ein Edelstahl-Substrat mit der Werkstoffnummer 1.4404 nach DIN verwendet.

Im Test zeigte das Schichtsystem eine Stabilität bis mind. 2,2 V gegenüber NHE (Normalwasserstoffelektrode) ex-situ unter harschen Elektrolysebedingungen in einem H₂SO₄-Elektrolyten bei pH4. Der Kontaktwiderstand vor und nach dieser elektrochemischen Belastung (Parameter siehe oben) beträgt < 3 mOhm_{*}cm² bei einem Anpressdruck von 100N/cm² und einer Messtemperatur von 24 °C.

Optisch und mikroskopisch wurde kein Schicht- und Substratangriff bis mindestens 2,2 V gegenüber NHE festgestellt. Als Substrat wurde ein Edelstahl-Substrat mit der Werkstoffnummer 1.4404 nach DIN verwendet.

Die Figuren 1 bis 4 sollen ein erfindungsgemäßes Schichtsystem sowie eine damit gebildete Elektrodenplatte in Form einer Bipolarplatte und eine Brennstoffzelle beispielhaft erläutern. So zeigt
- FIG 1: eine Bipolarplatte aufweisend das Schichtsystem;
- FIG 2: schematisch ein Brennstoffzellensystem umfassend mehrere Brennstoffzellen;
- FIG 3: einen Querschnitt durch eine Elektrodenplatte 2 mit einem beispielhaft dargestellten Schichtsystem in vergrößerter Darstellung, und
- FIG 4: eine Rasterelektronenmikroskopische Aufnahme einer Deckschicht.

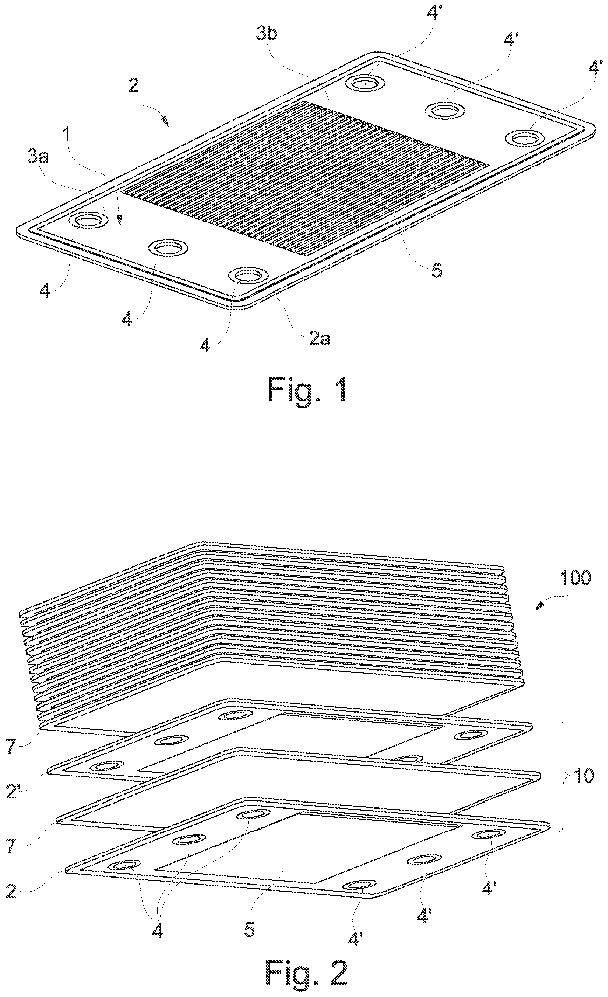

Figur 1 zeigt eine Elektrodenplatte 2 in Form einer Bipolarplatte mit einem Schichtsystem 1, die hier ein metallisches Substrat 2a beziehungsweise eine metallische Trägerplatte aus austenitischem Edelstahl aufweist. Die Bipolarplatte weist einen Einströmbereich 3a mit Öffnungen 4 sowie einen Auslassbereich 3b mit weiteren Öffnungen 4' auf, die zur Versorgung einer Brennstoffzelle mit Prozessgasen und Abführung von Reaktionsprodukten aus der Brennstoffzelle dienen. Die Bipolarplatte weist weiterhin auf jeder Seite eine Gasverteilerstruktur 5 auf, die zur Anlage an eine Polymerelektrolytmembrane 7 (vergleiche FIG 2) vorgesehen ist.

Figur 2 zeigt schematisch ein Brennstoffzellensystem 100 umfassend mehrere Brennstoffzellen 10. Jede Brennstoffzelle 10 umfasst eine Polymerelektrolytmembrane 7, die zu beiden Seiten von Elektrodenplatten 2, 2' in Form von Bipolarplatten benachbart ist. Gleiche Bezugszeichen wie in FIG 1 kennzeichnen gleiche Elemente.

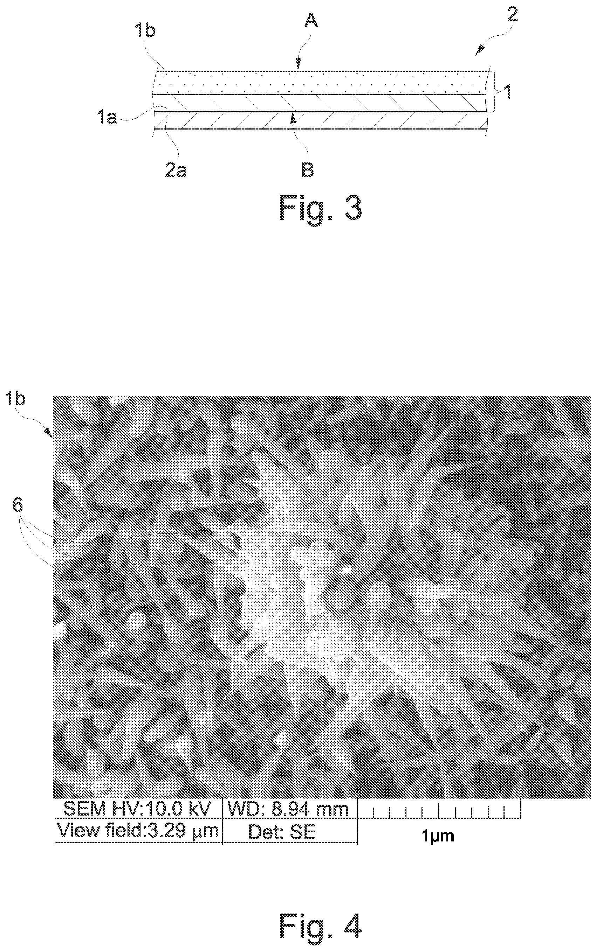

Figur 3 zeigt einen Querschnitt durch eine Elektrodenplatte 2 gemäß Figur 1. Es ist erkennbar, dass ein Substrat 2a, eine erste Beschichtung 1a und eine Deckschicht 1b vorhanden sind. Die erste Beschichtung 1a befindet sich auf einer Seite B des Schichtsystems 1, welche dem Substrat 2a zugewandt angeordnet ist. Die Deckschicht 1b befindet sich auf einer Seite A des Schichtsystems 1, die dem Substrat 2a der Elektrodenplatte 2 abgewandt angeordnet ist. Alternativ kann das Schichtsystem 1 auch mehrere erste Beschichtungen 1a aufweisen.

Figur 4 zeigt eine Rasterelektronenmikroskopische Aufnahme der Oberfläche einer Deckschicht 1b aus einem Netzwerk an Nanofasern 6, hier aus Indium-Zinn-Oxid.

### Bezugszeichenliste

- 1: Schichtsystem
- 1a: erste Beschichtung(en)
- 1b: Deckschicht
- 2, 2': Elektrodenplatte
- 2a: Substrat
- 3a: Einströmbereich
- 3b: Auslassbereich
- 4, 4': Öffnung
- 5: Gasverteilerstruktur
- 6: Nanofaser
- 7: Polymerelektrolytmembrane
- 10: Brennstoffzelle
- 100: Brennstoffzellensystem
- A: Seite des Schichtsystems 1, dem Substrat 2a abgewandt
- B: Seite des Schichtsystems 1, dem Substrat 2a zugewandt

## Patentansprüche

1. Schichtsystem (1) zum Beschichten eines Substrats (2a) zur Ausbildung einer Elektrodenplatte (2, 2'), umfassend zumindest eine erste Beschichtung (1a) aus Metalloxid, wobei die mindestens eine erste Beschichtung (1a) eine homogene, polykristalline dotierte Indium-Zinn-Oxid-Schicht ist und darauf eine Deckschicht (1b) in Form einer polykristallinen dotierten Indium-Zinn-Oxid-Schicht aus einem Netzwerk an Nanofasern (6) ausgebildet ist, wobei das Indium-Zinn-Oxid der mindestens einen ersten Beschichtung (1a) und der Deckschicht (1b) mit mindestens einem Element der Gruppe umfassend Kohlenstoff, Stickstoff, Bor, Fluor, Wasserstoff, Phosphor, Schwefel, Chlor, Brom, Aluminium, Silizium, Titan, Chrom, Kobalt, Nickel, Kupfer, Zirkon, Niob, Molybdän, Silber, Antimon, Hafnium, Tantal, Wolfram, dotiert ist.

2. Schichtsystem (1) nach Anspruch 1, wobei eine Schichtdicke des Schichtsystems (1) kleiner 1 µm beträgt.

3. Schichtsystem (1) nach Anspruch 1 oder Anspruch 2, wobei eine Konzentration der Elemente der Dotierung im Indium-Zinn-Oxid im Bereich von > 0 bis 20 at.-% liegt.

4. Schichtsystem (1) nach einem der Ansprüche 1 bis 3, wobei das Indium-Zinn-Oxid einen Indiumanteil im Bereich von 70 bis 90 at.-% aufweist.

5. Elektrodenplatte (2, 2'), insbesondere Bipolarplatte, umfassend ein Substrat (2a) sowie ein Schichtsystem (1) nach einem der Ansprüche 1 bis 4, mit einem Aufbau der Elektrodenplatte (2, 2') in der Reihenfolge:
Substrat (2a), und
mindestens eine erste Beschichtung (1a) aus Metalloxid und
Deckschicht (1b) aus Nanofasern.

6. Elektrodenplatte (2, 2') nach Anspruch 5, wobei das Substrat (2a) eine Dicke im Bereich von 0,001 bis 5mm aufweist.

7. Elektrodenplatte (2, 2') nach Anspruch 5 oder 6, wobei das Substrat (2a) aus einer Eisenlegierung, insbesondere aus Stahl, oder aus Titan oder einer Titan-Legierung oder Aluminium oder einer Aluminiumlegierung oder Zink oder einer Zink-Legierung oder einer Zinn-Legierung oder Kupfer oder einer Kupferlegierung oder Nickel oder einer Nickellegierung oder Silber oder einer Silberlegierung oder Chrom oder einer Chromlegierung oder auf Graphit-Basis gebildet ist.

8. Elektrodenplatte (2, 2') nach einem der Ansprüche 5 bis 7, wobei das Substrat (2a) ein metallisches Substrat (2a) ist.

9. Brennstoffzelle (10), insbesondere Sauerstoff-Wasserstoff-Brennstoffzelle, oder Elektrolyseur oder Redox-Flow-Zelle, umfassend mindestens eine Elektrodenplatte (2, 2') nach einem der Ansprüche 5 bis 8.

10. Brennstoffzelle (10) nach Anspruch 9, umfassend mindestens eine Polymerelektrolytmembrane (7).

11. Verfahren zur Herstellung einer Elektrodenplatte (2, 2') nach Anspruch 5 mit den folgenden Schritten:
Bereitstellen des Substrats (2a);
Ausbilden der mindestens einen ersten Beschichtung (1a) auf dem Substrat (1a),
Ausbilden der Deckschicht (1b) auf der mindestens einen ersten Beschichtung (1a),
wobei die mindestens eine erste Beschichtung (1a) und die Deckschicht (1b) aus Metalloxid auf dem Substrat (2a) mittels nicht-reaktiven Sputterns mit einem amorphen Gefüge ausgebildet werden; und
Tempern der mindestens einen ersten Beschichtung (1a) und der Deckschicht (1b) bei einer Temperatur im Bereich von 220 bis 400 °C derart, dass das amorphe Gefüge in ein polykristallines Gefüge umgewandelt wird.

## Claims

1. A layered system (1) for coating a substrate (2a) to form an electrode plate (2, 2'), comprising at least one first coating (1a) of metal oxide, wherein the at least one first coating (1a) is a homogeneous, polycrystalline doped indium tin oxide layer and a top layer (1b) in the form of a polycrystalline doped indium tin oxide layer of a network of nanofibres (6) is formed thereon, wherein the indium tin oxide of the at least one first coating (1a) and the top layer (1b) is doped with at least one element from the group comprising carbon, nitrogen, boron, fluorine, hydrogen, phosphorus, sulphur, chlorine, bromine, aluminium, silicon, titanium, chromium, cobalt, nickel, copper, zirconium, niobium, molybdenum, silver, antimony, hafnium, tantalum and tungsten.

2. The layered system (1) according to claim 1, wherein a layer thickness of the layered system (1) is less than 1 µm.

3. The layered system (1) according to claim 1 or claim 2, wherein the concentration of the doping elements in the indium tin oxide is in the range of > 0 to 20 at%.

4. The layered system (1) according to any one of claims 1 to 3, wherein the indium tin oxide has an indium proportion in the range of 70 to 90 at%.

5. An electrode plate (2, 2'), in particular a bipolar plate, comprising a substrate (2a) and a layered system (1) according to any of claims 1 to 4, having a structure of the electrode plate (2, 2') in this order:
substrate (2a), and
at least one first coating (1a) of metal oxide and
top layer (1b) made of nanofibres.

6. The electrode plate (2, 2') according to claim 5, wherein the substrate (2a) has a thickness in the range of 0.001 to 5 mm.

7. The electrode plate (2, 2') according to claim 5 or 6, wherein the substrate (2a) is formed from an iron alloy, in particular steel, or from titanium or a titanium alloy or aluminium or an aluminium alloy or zinc or a zinc alloy or a tin alloy or copper or a copper alloy or nickel or a nickel alloy or silver or a silver alloy or chromium or a chromium alloy or is graphite-based.

8. The electrode plate (2, 2') according to any one of claims 5 to 7, wherein the substrate (2a) is a metallic substrate (2a).

9. A fuel cell (10), in particular an oxygen-hydrogen fuel cell, or electrolyser or redox-flow battery, comprising at least one electrode plate (2, 2') according to any one of claims 5 to 8.

10. The fuel cell (10) according to claim 9, comprising at least one polymer electrolyte membrane (7).

11. A method for producing an electrode plate (2, 2') according to claim 5, having the following steps:
providing the substrate (2a);
forming the at least one first coating (1a) on the substrate (1a), forming the top layer (1b) on the at least one first coating (1a), wherein the at least one first coating (1a) and the top layer (1b) of metal oxide are formed on the substrate (2a) by means of non-reactive sputtering with an amorphous structure; and
tempering the at least one first coating (1a) and the top layer (1b) at a temperature in the range of 220 to 400°C such that the amorphous structure is transformed into a polycrystalline structure.

## Revendications

1. Système de couches (1) pour revêtir un substrat (2a) afin de former une plaque d'électrode (2, 2'), comprenant au moins un premier revêtement (1a) d'oxyde métallique, dans lequel l'au moins un premier revêtement (1a) est une couche homogène polycristalline d'oxyde d'indium-étain dopé et par-dessus est formée une couche de couverture (1b) sous la forme d'une couche polycristalline d'oxyde d'indium-étain dopé d'un réseau de nanofibres (6), dans lequel l'oxyde d'indium-étain de l'au moins un premier revêtement (1a) et de la couche de couverture (1b) est dopé avec au moins un élément du groupe comprenant le carbone, l'azote, le bore, le fluor, l'hydrogène, le phosphore, le soufre, le chlore, le brome, l'aluminium, le silicium, le titane, le chrome, le cobalt, le nickel, le cuivre, le zirconium, le niobium, le molybdène, l'argent, l'antimoine, le hafnium, le tantale, le tungstène.

2. Système de couches (1) selon la revendication 1, dans lequel l'épaisseur de couche du système de couches (1) est inférieure à 1 µm.

3. Système de couches (1) selon la revendication 1 ou la revendication 2, dans lequel une concentration des éléments dopants dans l'oxyde d'indium-étain se situe dans la plage de > 0 à 20 % atomiques.

4. Système de couches (1) selon l'une quelconque des revendications 1 à 3, dans lequel l'oxyde d'indium-étain présente une proportion d'indium dans la plage de 70 à 90 % atomiques.

5. Plaque d'électrode (2, 2'), en particulier plaque bipolaire, comprenant un substrat (2a) ainsi qu'un système de couches (1) selon l'une quelconque des revendications 1 à 4, comportant une structure de la plaque d'électrode (2, 2') dans l'ordre :
un substrat (2a), et
au moins un premier revêtement (1a) d'oxyde métallique et
une couche de couverture (1b) de nanofibres.

6. Plaque d'électrode (2, 2') selon la revendication 5, dans laquelle le substrat (2a) présente une épaisseur dans la plage de 0,001 à 5 mm.

7. Plaque d'électrode (2, 2') selon la revendication 5 ou 6, dans laquelle le substrat (2a) est formé d'un alliage de fer, en particulier d'acier, ou de titane ou d'un alliage de titane ou d'aluminium ou d'un alliage d'aluminium ou de zinc ou d'un alliage de zinc ou d'un alliage d'étain ou de cuivre ou d'un alliage de cuivre ou de nickel ou d'un alliage de nickel ou d'argent ou d'un alliage d'argent ou de chrome ou d'un alliage de chrome ou est à base de graphite.

8. Plaque d'électrode (2, 2') selon l'une quelconque des revendications 5 à 7, dans laquelle le substrat (2a) est un substrat (2a) métallique.

9. Pile à combustible (10), en particulier pile à combustible oxygène-hydrogène, ou électrolyseur ou pile à flux rédox, comprenant au moins une plaque d'électrode (2, 2') selon l'une quelconque des revendications 5 à 8.

10. Pile à combustible (10) selon la revendication 9, comprenant au moins une membrane électrolytique polymère (7).

11. Méthode de fabrication d'une plaque d'électrode (2, 2') selon la revendication 5 comportant les étapes suivantes :
fourniture du substrat (2a) ;
formation d'au moins un premier revêtement (1a) sur le substrat (1a), formation de la couche de couverture (1b) sur l'au moins un premier revêtement (1a), dans lequel l'au moins un premier revêtement (1a) et la couche de couverture (1b) sont formées d'oxyde métallique sur le substrat (2a) par le biais d'une pulvérisation cathodique non réactive avec une structure amorphe ; et
recuit de l'au moins un premier revêtement (1a) et de la couche de couverture (1b) à une température dans la plage de 220 à 400 °C de sorte que la structure amorphe est transformée en une structure polycristalline.
